(19) Europäisches Patentamt
European Patent Office
Office européen des brevets

(11) EP 4 585 343 A1

(12) EUROPEAN PATENT APPLICATION

(43) Date of publication:
16.07.2025 Bulletin 2025/29

(51) International Patent Classification (IPC):
B23K 9/095 (2006.01)    B23K 9/10 (2006.01)

(21) Application number: 24220895.7

(22) Date of filing: 18.12.2024

(52) Cooperative Patent Classification (CPC):
B23K 9/0953; B23K 9/1056; G01R 31/3646;
H02J 7/0048

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 20.12.2023 JP 2023214969

(71) Applicant: Yamabiko Corporation
Ohme-shi
Tokyo 198-8760 (JP)

(72) Inventor: ARAKAWA, Takuya
Tokyo, 198-8760 (JP)

(74) Representative: Canzler & Bergmeier
Patentanwälte
Partnerschaft mbB
Despag-Straße 6
85055 Ingolstadt (DE)

(54) BATTERY WELDER

(57) It is to make it possible to accurately know how many welding rods can be welded from now on under the current battery condition.

A battery welder includes: a welding output device to which a welding rod is connected; a welding control device configured to control a welding output by a set welding current value; a battery device configured to supply electric power to the welding output device via the welding control device; and a computation and display device configured to compute a battery condition of the battery device and display a computation result. The computation and display device calculates a number of welding rods that can be welded from a welding output for each of welding current values based on a remaining battery capacity acquired from the battery device and displays the number of welding rods that can be welded.

FIG. 1

## Description

BACKGROUND

1. Technical field

The present invention relates to a battery welder.

2. Related Art

Conventionally, a battery welder includes a transformer connected to an AC power source, a rectifier circuit configured to convert the output of the transformer to a full rectified wave form whose phase is controlled, and a battery connected to the rectifier circuit in series. Welding power is obtained from both ends of the battery charged by the AC source. In addition, a conventional battery welder has been known, which includes a liquid level sensor configured to detect the liquid in the battery being decreased; a charging voltage sensing circuit; a charging current sensing circuit; a phase angle control circuit configured to control the rectifier circuit; and a condition display device configured to display the condition of the battery, as well as the above-described components (see, Japanese Patent Application Lais-Open No. H5-95146).

According to the above-described related art, the condition display device configured to display the condition of the battery displays an alarm when the liquid of the battery is decreased and also displays the remaining battery capacity. Here, generally, the remaining battery capacity is represented by using an indicator with different colors, or by displaying state of charge (%).

The battery welder according to this related art needs to change the set welding current depending on the condition of use, and the power consumption varies depending on the change in welding current. This causes a problem that it is difficult to intuitively and correctly know how long the work can be continued from now on by the current remaining battery capacity.

In particular, in the case of the battery welder using welding rods, the set welding current is changed depending on the diameter of a welding rod. However, according to the conventional representation of the remaining battery capacity, it is not possible to accurately know how many welding rods can be welded from now on by the current remaining battery capacity. This causes a problem that it is not possible to make a detailed schedule to continue the welding work.

SUMMARY

The present invention is proposed to address the above-described problems. That is, the problems to be solved by the invention are to make it possible in a battery welder to intuitively and correctly know how long the work can be continued from now on under the current battery condition, and to make it possible in the battery welder to accurately know how many welding rods can be welded from now on under the current battery condition, and therefore to make a detailed schedule to continue the welding work.

To solve the above-described problems, a battery welder according to the invention includes: a welding output device to which a welding rod is connected; a welding control device configured to control a welding output by a set welding current value; a battery device configured to supply electric power to the welding output device via the welding control device; and a computation and display device configured to compute a battery condition of the battery device and display a computation result. The computation and display device calculates a remaining battery capacity based on information acquired from the battery device, calculates a number of welding rods that can be welded from a welding output for each of welding current values, and displays the number of welding rods that can be welded.

According to the invention having the above-described features, it is possible to intuitively and correctly know how long the battery welder can continue the work from now on under the current battery condition. In addition, it is possible to accurately know how many welding rods can be welded by under the current battery condition. By this means, it is possible to make a detailed schedule to continue the welding work, and in particular, it is possible to make a right decision on whether the welding work should be continued or the battery device should be charged.

BRIEF DESCRIPTION OF THE DRAWINGS

Fig. 1 is a view for illustrating an example of the configuration of a battery welder according to an embodiment of the invention;
Fig. 2 is a flowchart illustrating a process of computing the number of welding rods that can be welded;

Fig. 3 is a view for illustrating the relationship between welding current values and correction values;

Fig. 4 is a view for illustrating an example of the external configuration of a computation and display device;

Fig. 5 is a view for illustrating an example of the external configuration of the computation and display device; and

Fig. 6 is a flowchart illustrating an example of the operation of the battery welder.

DETAILED DESCRIPTION

Hereinafter, an embodiment of the present invention will be described with reference to the drawings. The same reference numbers in the different drawings indicate the same functional parts, and therefore repeated description for each of the drawings is omitted.

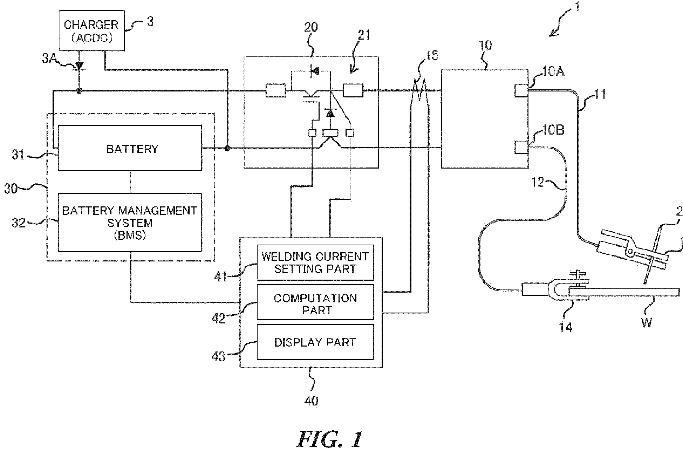

As illustrated in Fig. 1, a battery welder 1 includes a welding output device 10, a welding control device 20, a battery device 30, and a display and computation device 40.

The welding output device 10 to which a welding rod 2 is connected includes output terminals 10A and 10B. One end of a welding rod connecting cable 11 is connected to the output terminal 10A, and one end of a workpiece connecting cable 12 is connected to the output terminal 10B. The welding rod 2 is connected to the other end of the welding rod connecting cable 11 via a welding rod holder 13. A workpiece W is connected to the other end of the workpiece connecting cable 12 via a workpiece clamp 14.

The welding control device 20 is configured to control welding outputs of the welding output device 10 by a set welding current. The power supplied from the battery device 30 is controlled by a gate drive 21 to supply the set welding current to the welding output device 10.

The battery device 30 includes a battery 31 configured to supply electric power to the welding output device 10 via the welding control device 20. An example of the battery 31 is a lithium-ion battery which may be a single battery cell or may be constituted by connecting a plurality of battery cells. The battery 31 is connected to a charger (ACDC charger) 3 via a diode 3A and can be charged by an AC power source (not illustrated) connected to the charger 3.

In addition, the battery device 30 includes a battery management system (BMS) 32 to manage the condition of the battery. The battery management system 32 recognizes the battery capacity (rated capacity) of the battery 31; consecutively monitors the condition of the battery 31; outputs the battery voltage, the charge/discharge current, the integrated value of the charge/discharge current as consecutive information; and, when a trigger to stop charging or discharging occurs, records that.

The computation and display device 40 includes a welding current setting part 41 configured to set a welding current to the welding control device 20; a computation part 42 configured to perform computations based on information from the battery management system 32, and information from a current detector 15 configured to detect the welding current outputted from the welding control device 20; and a display part 43 configured to display the computation result of the computation part 42.

The computation and display device 40 may be constituted by a control board. The welding current setting part 41 may be constituted by, for example, a voltage regulation circuit to regulate the input voltage of the gate drive 21 of the welding control device 20. The computation part 42 may be constituted by a processor such as a CPU (central processing device) or an MPU (micro processing device), and a storage element such as a RAM (random access memory) or a ROM (read only memory), which are mounted on the control board. The display part 43 may be constituted by software embedded in a processor such as a CPU and an MPU mounted on the control board, or an electronic circuit (monitoring circuit) mounted on the control board, and a display part (display panel) actuated by the software or the electric circuit.

The welding current setting part 41 of the computation and display device 40 is operated in response to an adjustment operation of a current regulation circuit by the user to set a welding current (welding current value) outputted from the welding control device 20. The welding current value is set as an appropriate value depending on the type, the diameter, and the welding posture of the welding rod. To be more specific, it is possible to determine the welding current value as illustrated in Table 1 as an example. Here, Table 1 illustrates proper welding current values for each of coating types (an ilmenite type and a low-hydrogen type) at the thickness (the diameter: 2.6 to 8.0 φ) only in a limited case where the welding rods face downward.

<Table 1>

| Coating type | 2.6φ | 3.2φ | 4.0φ | 4.5φ | 5.0φ | 6.0φ | 7.0φ | 8.0φ |
|---|---|---|---|---|---|---|---|---|
| Ilmenite | 55-90 | 85-140 | 130-190 | 155-220 | 180-260 | 240-310 | 300-370 | 350-440 |
| Low-hydrogen | 55-85 | 90-130 | 130-180 | 150-210 | 180-240 | 250-310 | 300-380 | 340-440 |

The computation part 42 of the computation and display device 40 calculates "the number of welding rods that can be welded" indicating how many welding rods can be welded from now on, based on the current condition of the battery 31 and the set welding current value, from the information obtained from the battery management system 32, and outputs the calculation result to the display part 43.

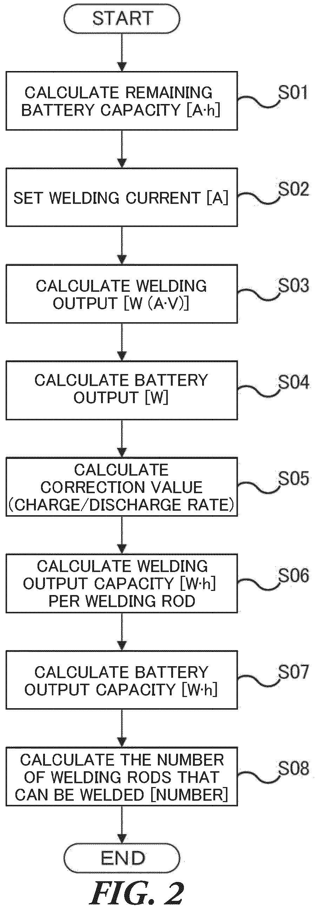

The computation part 42 calculates the remaining battery capacity based on the information obtained from the battery management system 32 of the battery device 30, calculates the number of welding rods that can be welded based on the welding output for each of the set welding current values, and displays the number of welding rods that can be welded. With reference to Fig. 2, a process of computation performed by the computation part 42 will be specifically described.

In step S01 of Fig. 2, the computation part 42 calculates a remaining battery capacity [A·h], based on the battery capacity (rated capacity) [A·h] and the integrated value of the charge/discharge current (time integration value) [A·h] of the battery 31 obtained from the battery management system 32. The remaining battery capacity (FCC_cal) is calculated based on the battery capacity (FCC) and the integrated value of the charge/discharge current (current sum), according to the following equation (1).

$$FCC\_cal = FCC - current\_sum \quad (1)$$

In step S02 of Fig. 2, the computation part 42 recognizes the welding current [A] set by the welding current setting part 41 of the computation and display device 40 as the welding current value (preset).

In step S03 of Fig. 2, the computation part 42 calculates a welding output [W (A·V)] (weld w) based on the set welding current value (preset) and the rated voltage (output voltage: weld v) for the welding current value, according to the following equation (2) .

$$weld\_w = preset \times weld\_v \quad (2)$$

In step 04 of Fig. 2, the computation part 42 sets conversion efficiency due to passing through the welding control device 20 to a predetermined value (for example, 80 %), and calculates a battery output [W] (battery out) according to the following equation (3) .

$$battery\ out = weld\ w/0.8 \quad (3)$$

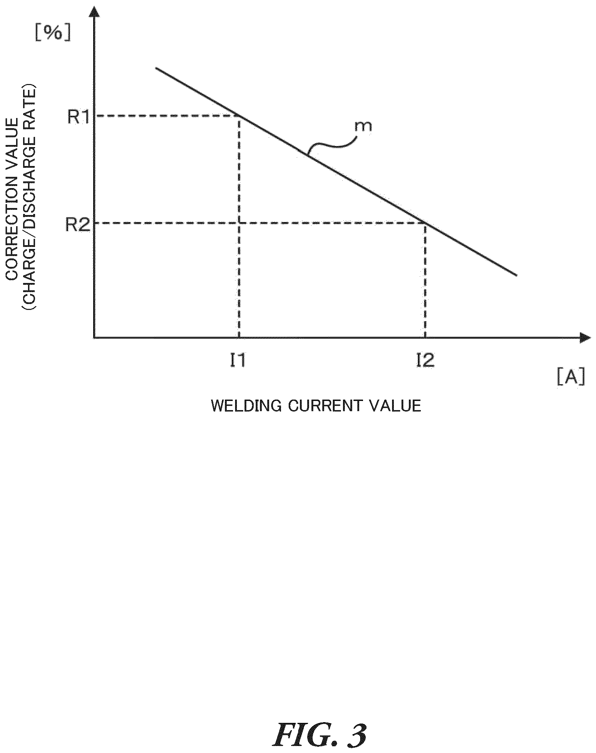

In step S05 of Fig. 2, the computation part 42 calculates a correction value (charge/discharge rate). This correction value (conv eff) is obtained by a correction line m illustrated in Fig. 3. The correction line m is a straight line to calculate the correction value for each of the set welding current values (preset). Here, the correction value (conv eff) is a charge/ discharge rate (0<conv eff<1) based on the internal resistance of the battery 31. The higher the welding current value (preset) is, the lower the correction value (conv eff) is. With the illustrated example, provided that the correction value is R1 at the welding current value I1, and the correction value is R2 at the welding current value I2, when I1 is lower than I2 (I1<I2), R2 is lower than R1 (R2<R1). The correction value (conv eff) is obtained from constants S and T preset by a pretest, according to the following equation (4).

$$conv\ eff = preset \times S + T \quad (4)$$

In step S06 of Fig. 2, the computation part 42 calculates a welding output capacity [W·h] per welding rod. The welding output capacity per welding rod (one wed out) is obtained by converting the welding output (weld w) for each of the set welding current values (preset) to the battery output (battery out) according to the above-described equation (3), and correcting the converted battery output (battery out) with the correction value (conv eff) obtained for each of the welding current values (preset). As an example, provided that the welding output for one welding rod continues for one minute, the welding output capacity can be calculated by multiplying the battery output [W] (battery out) by the correction value (conv eff) and converting the multiplication result to a value per one minute, according to the following equation (5) .

$$one\_weld\_out = battery\_out \times conv\_eff/60 \quad (5)$$

In step S07 of Fig. 2, the computation part 42 calculates a battery output capacity [W·h] (FCC w) based on the remaining battery capacity (FCC cal). Here, the battery output capacity (FCC w) is calculated by multiplying the battery voltage (battery v) obtained from the battery management system 32 by the remaining battery capacity (FCC cal), according to the following equation (6).

$$FCC\_w = battery\_v \times FCC\_cal \quad (6)$$

In step S08 of Fig. 2, the computation part 42 calculates the number of welding rods that can be welded [number]. The number of welding rods that can be welded (weld number) is calculated by dividing the battery output capacity (FCC w) by the welding output capacity per welding rod (one weld out), according to the following equation (7).

$$weld\_number = FCC\_w / one\_weld\_out \quad (7)$$

The number of welding rods that can be welded, which is calculated through the step S01 to step S08, is the value for each of the set welding current values and is calculated in consideration of the correction value (charge/discharge rate) varying for each of the set welding current values, and therefore is more precise than the remaining battery capacity at present. In addition, the number of welding rods that can be welded is calculated with high precision, because the remaining battery capacity itself is calculated from the integrated values of the charge/discharge currents managed by the battery management system 32.

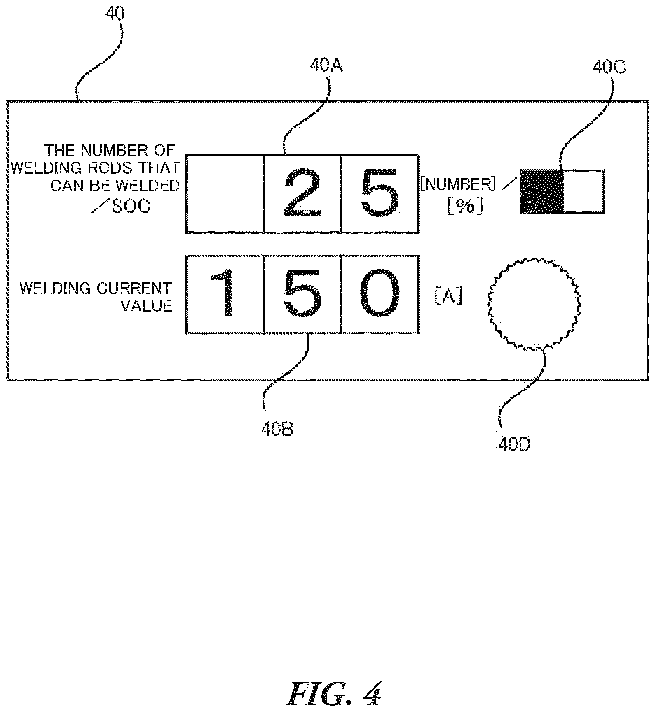

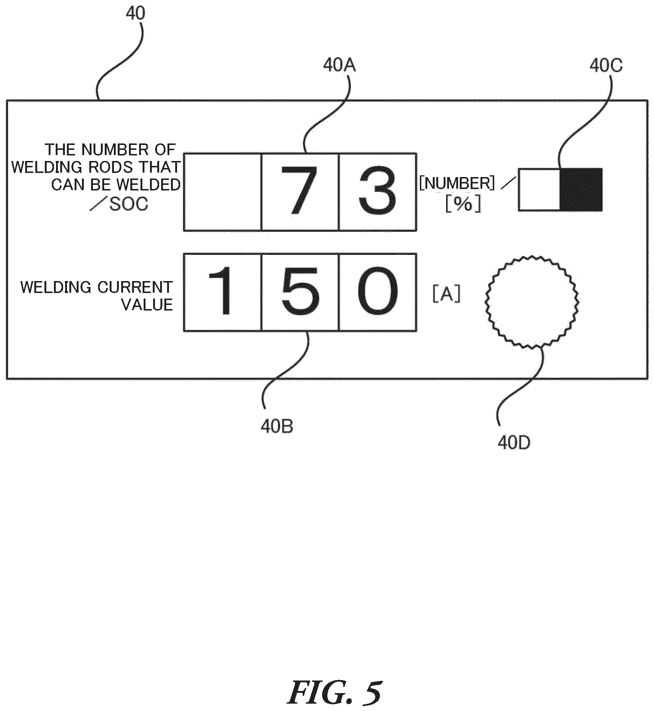

Fig. 4 and Fig. 5 illustrate an example of the external configuration of the computation and display device 40 of the battery welder 1. With this example, the computation and display device 40 includes two display panels 40A and 40B. The display panel 40A can selectively displays the number of welding rods that can be welded, and the charging rate (SOC: state of charge) of the battery 31. Meanwhile, the display panel 40B displays a set welding current value. To switch the display item on the display panel 40A, the display selector switch 40C is switched to "ON" as illustrated in Fig. 4 or switched to "OFF" as illustrated in Fig. 5. An adjustment volume 40D is operated to allow the set welding current value to be changed. The changed set welding current value is displayed on the display panel 40B. Here, although the example of switching the display item on the display panel 40A is illustrated, the number of welding rods that can be welded and the SOC may be displayed in parallel on a plurality of display panels.

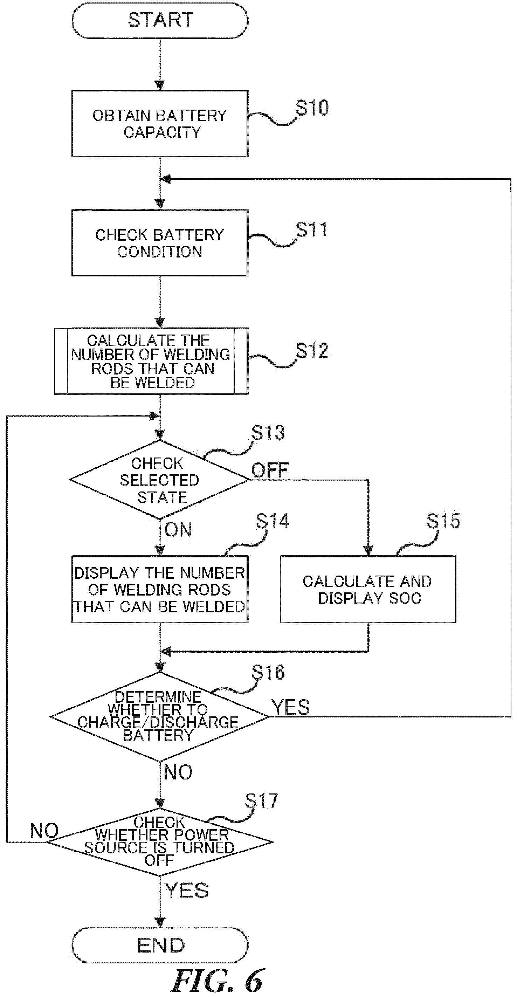

Fig. 6 illustrates an example of operation of the battery welder 1. After start of the operation, the computation and display device 40 acquires information from the battery device 30 to obtain the battery capacity of the battery 31 (step S10) and check the battery condition of the battery 31 (step S11). Then, the computation and display device 40 performs above-described step S01 to step S08 of the process to calculate the number of welding rods that can be welded under the current condition of the battery 31 (step S12). Here, when the welding current is set in the step S02, the value of the set welding current is displayed on the display panel 40B.

Then, the selected state of the display selector switch 40C is checked (step S13), and when the "ON" state is selected as illustrated in Fig. 4 (the step 13 "ON"), the calculated number of welding rods that can be welded is displayed on the display panel 40A (step S14). Meanwhile, when the display selector switch 40C is in the "OFF" state as illustrated in Fig. 5 (the step S13 "OFF", the charging rate (SOC) is calculated based on the information acquired from the battery device 30 and is displayed on the display panel 40A (step S15). Here, the charging rate (SOC) can be calculated based on the remaining battery capacity (FCC cal) and the battery capacity (FCC) described above, according to the following equation (8) .

$$SOC = (FCC\_cal / FCC) \times 100 \quad (8)$$

Then, when determining to charge or discharge the battery 31 based on the information acquired from the battery device 30 (step S16 "YES"), the computation and display device 40 performs the step S11 to S14 or the step S11 to S15 to display the display items on the display panels 40A as described above. When determining not to charge or discharge the battery 31 (step S16 "NO"), the computation and display device 40 checks that the power source is turned off (step S17 "YES"), and the process ends. When the computation and display device 40 checks that the power source is not turned off (step S17 "NO"), the steps 13 to 15 are performed to display the display items as described above.

According to this battery welder 1, it is possible to precisely display the number of welding rods that can be welded, and therefore to intuitively and correctly know how long the work can be continued from now on under the current battery condition. By this means, it is possible to make a detailed schedule to continue the welding work. In particular, it is possible to make a right decision on whether the welding work should be continued or the battery device 30 should be charged.

**List** of reference signs

    1: battery welder
    2: welding rod

3: charger
3A: diode
10: welding output device
10A, 10B: output terminal
11: welding rod connecting cable
12: workpiece connecting cable
13: welding rod holder
14: workpiece clamp
15: current detector
20: welding control device
21: gate drive
30: battery device
31: battery
32: battery management system (BMS)
40: computation and display device
40A, 40B: display panel
40C: display selector switch
40D: adjustment volume
41: welding current setting part
42: computation part
43: display part
m: correction line
W: workpiece

**Claims**

1. A battery welder comprising:

   a welding output device to which a welding rod is connected;
   a welding control device configured to control a welding output by a set welding current value;
   a battery device configured to supply electric power to the welding output device via the welding control device; and
   a computation and display device configured to compute a battery condition of the battery device and display a computation result,
   wherein the computation and display device calculates a remaining battery capacity based on information acquired from the battery device, calculates a number of welding rods that can be welded from a welding output for each of welding current values, and displays the number of welding rods that can be welded.

2. The battery welder according to claim 1, wherein the remaining battery capacity is calculated from an integrated value of a charge/discharge current of the battery device.

3. The battery welder according to claim 1 or 2, wherein the number of welding rods that can be welded is calculated by calculating a welding output capacity per welding rod, and dividing a battery output capacity based on the remaining battery capacity by the welding output capacity per welding rod.

4. The battery welder according to claim 3, wherein the welding output capacity per welding rod is calculated by converting the welding output for each of the welding current values to a battery output, and correcting the converted battery output with a correction value previously calculated for each of the welding current values.

5. The battery welder according to claim 4, wherein:

   the correction value is a charge/discharge rate with respect to the welding current value; and
   the higher the welding current value is, the lower the charge/discharge rate.

6. The battery welder according to any of the preceding claims, the computation and display device can display the number of welding rods that can be welded, and a charging rate calculated from the remaining battery capacity.

*FIG. 1*

START

CALCULATE REMAINING
BATTERY CAPACITY [A·h] — S01

SET WELDING CURRENT [A] — S02

CALCULATE WELDING
OUTPUT [W (A·V)] — S03

CALCULATE BATTERY
OUTPUT [W] — S04

CALCULATE
CORRECTION VALUE
(CHARGE/DISCHARGE RATE) — S05

CALCULATE WELDING
OUTPUT CAPACITY [W·h]
PER WELDING ROD — S06

CALCULATE BATTERY
OUTPUT CAPACITY [W·h] — S07

CALCULATE THE NUMBER
OF WELDING RODS THAT
CAN BE WELDED [NUMBER] — S08

END

*FIG. 2*

*FIG. 3*

40

40A

40C

THE NUMBER OF
WELDING RODS THAT
CAN BE WELDED
／SOC

2 5

[NUMBER] ／
[%]

WELDING CURRENT
VALUE

1 5 0

[A]

40B

40D

*FIG. 4*

40

40A

40C

THE NUMBER OF
WELDING RODS THAT
CAN BE WELDED
/SOC

7 3  [NUMBER]／
[%]

WELDING CURRENT
VALUE

1 5 0  [A]

40B

40D

*FIG. 5*

START

OBTAIN BATTERY CAPACITY — S10

CHECK BATTERY CONDITION — S11

CALCULATE THE NUMBER OF WELDING RODS THAT CAN BE WELDED — S12

CHECK SELECTED STATE — S13

OFF → CALCULATE AND DISPLAY SOC — S15

ON → DISPLAY THE NUMBER OF WELDING RODS THAT CAN BE WELDED — S14

DETERMINE WHETHER TO CHARGE/DISCHARGE BATTERY — S16

YES

NO

CHECK WHETHER POWER SOURCE IS TURNED OFF — S17

NO

YES

END

*FIG. 6*

Europäisches
Patentamt

European
Patent Office

Office européen
des brevets

# EUROPEAN SEARCH REPORT

Application Number

EP 24 22 0895

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 102 059 362 B1 (KOH JEANG CHEAL [KR]) 26 December 2019 (2019-12-26) * abstract * * paragraphs [0008], [0011], [0064] - [0067], [0076] - [0086] * * figures 2,10,12 * * claim 1 * | 1-6 | INV. B23K9/095 B23K9/10 |
| A | US 2012/175356 A1 (MAGERL CHRISTIAN [AT] ET AL) 12 July 2012 (2012-07-12) * abstract * * paragraphs [0011] - [0015] * * figures 1,4,5 * | 1-6 | |
| A | US 2018/185948 A1 (KNOENER CRAIG STEVEN [US] ET AL) 5 July 2018 (2018-07-05) * abstract * * paragraphs [0052] - [0053], [0058] * | 1-6 | |

TECHNICAL FIELDS
SEARCHED        (IPC)

B23K

The present search report has been drawn up for all claims

| Place of search | Date of completion of the search | Examiner |
|---|---|---|
| Munich | 6 June 2025 | Perret, William |

EPO FORM 1503 03.82 (P04C01)

## ANNEX TO THE EUROPEAN SEARCH REPORT
## ON EUROPEAN PATENT APPLICATION NO.

EP 24 22 0895

This annex lists the patent family members relating to the patent documents cited in  the above-mentioned European search report.
The members are as contained in the European Patent Office EDP file on
The European Patent Office is in no way liable for these particulars which are merely given for the purpose of information.

06-06-2025

| Patent document cited in search report | Publication date | Patent family member(s) | | Publication date |
|---|---|---|---|---|
| KR 102059362 B1 | 26-12-2019 | NONE | | |
| US 2012175356 A1 | 12-07-2012 | AT | 508692 A1 | 15-03-2011 |
| | | BR | 112012005426 A2 | 12-04-2016 |
| | | CN | 102596479 A | 18-07-2012 |
| | | EP | 2475491 A1 | 18-07-2012 |
| | | JP | 2013504427 A | 07-02-2013 |
| | | RU | 2012113829 A | 20-10-2013 |
| | | US | 2012175356 A1 | 12-07-2012 |
| | | WO | 2011029113 A1 | 17-03-2011 |
| US 2018185948 A1 | 05-07-2018 | CA | 2989549 A1 | 04-07-2018 |
| | | CN | 108262581 A | 10-07-2018 |
| | | EP | 3351334 A1 | 25-07-2018 |
| | | US | 2018185948 A1 | 05-07-2018 |

EPO FORM P0459

For more details about this annex : see Official Journal of the European Patent Office, No. 12/82